(19)

Europäisches Patentamt
European Patent Office
Office européen des brevets

(11) **EP 3 409 652 A1**

(12) **EUROPEAN PATENT APPLICATION**

(43) Date of publication:
**05.12.2018 Bulletin 2018/49**

(21) Application number: **17382320.4**

(22) Date of filing: **31.05.2017**

(51) Int Cl.:
*C04B 35/462* (2006.01)   *C04B 35/472* (2006.01)
*C04B 35/626* (2006.01)   *C04B 35/64* (2006.01)
*H01L 41/43* (2013.01)   *H01L 41/187* (2006.01)
*H01G 4/12* (2006.01)   *G01R 33/09* (2006.01)
*H01L 43/08* (2006.01)

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(71) Applicant: **Consejo Superior de Investigaciones
Científicas
(CSIC)
28006 Madrid (ES)**

(72) Inventors:
• **ALGUERÓ GIMÉNEZ, Miguel
  28049 MADRID (ES)**
• **AMORÍN GONZÁLEZ, Harvey
  28049 MADRID (ES)**
• **CASTRO LOZANO, Alicia
  28049 MADRID (ES)**

(74) Representative: **Pons
  Glorieta Ruben Dario 4
  28010 Madrid (ES)**

(54) **A HIGH TEMPERATURE AND VOLTAGE RESPONSE PIEZOELECTRIC, BISCO3-PBTIO3 BASED CERAMIC MATERIAL MICROSTRUCTURALLY ENGINEERED FOR ENHANCED MECHANICAL PERFORMANCE, A PROCEDURE FOR OBTAINING SAID CERAMIC MATERIAL AND ITS USE AS SENSING DEVICE**

(57) The invention relates to a fully dense and ultrafine grained high temperature piezoelectric $BiScO_3$-$PbTiO_3$ ceramic material of formula $Bi_{1-x+2y}Pb_{x-3y}Sc_{1-x}Ti_xO_3$, wherein x ranges from 0.64 to 0.68 and y ranges from 0.01 to 0,025, which includes a point defect engineering for high voltage response and an optimized microstructure for enhanced fracture strength. Furthermore, the invention refers to a process for obtaining said piezoelectric ceramic material by hot pressing of nanocrystalline powders derived by mechanosynthesis from a stoichiometric mixture of precursors and to the use of said piezoelectric ceramic material as part of a sensing device. Moreover, the invention relates a magnetoelectric composite comprising said piezoelectric ceramic material and a magnetostrictive material, the process for obtaining said magnetoelectric composite and its use as part of a magnetic sensing device.

EP 3 409 652 A1

**Description**

The invention relates to a fully dense and ultrafine grained high temperature piezoelectric $BiScO_3$-$PbTiO_3$ ceramic material of formula $Bi_{1-x+2y}Pb_{x-3y}Sc_{1-x}Ti_xO_3$, wherein x ranges from 0.64 to 0.68 and y ranges from 0.01 to 0,025, which includes a point defect engineering for high voltage response and an optimized microstructure for enhanced fracture strength. Furthermore, the invention refers to a process for obtaining said piezoelectric ceramic material by hot pressing of nanocrystalline powders derived by mechanosynthesis from a stoichiometric mixture of precursors and to the use of said piezoelectric ceramic material as part of a sensing device. Moreover, the invention relates a magnetoelectric composite comprising said piezoelectric ceramic material and a magnetostrictive material, the process for obtaining said magnetoelectric composite and its use as part of a magnetic sensing device.

**STATE OF ART**

$BiScO_3$-$PbTiO_3$ is the most promising system among general formula $BiMO_3$-$PbTiO_3$, wherein M is a trivalent cation in octahedral coordination, perovskite solid solutions with enhanced electromechanical response at ferroelectric morphotropic phase boundaries (MPB), and high Curie temperature. This material is being extensively investigated as an alternative to state of the art $Pb(Zr,Ti)O_3$ (PZT) for expanding the operation temperature of high sensitivity piezoelectric ceramics beyond 200 ºC up to 400 ºC.

Specifically, the binary system $(1-x)BiScO_3$-$xPbTiO_3$ presents a MPB between ferroelectric polymorphic phases of rhombohedral $R3m$ and tetragonal $P4mm$ symmetry at x ~ 0.64, composition for which the Curie temperature $T_C$ is $\approx$ 450 ºC, while piezoelectric coefficients $d_{33}$ of ~ 450 pC/N are typically achieved after poling. This $T_C$ is 100 ºC above that of $Pb(Zr,Ti)O_3$, likewise $d_{33}$ that also significantly exceeds the figure of $\approx$ 245 pC/N for ceramics of the latter material at its own MPB. Moreover, the charge piezoelectric coefficient is comparable to those of available commercial high sensitivity piezoelectric ceramics of chemically engineered PZT.

However, and in spite of the theoretically expanded operation temperature range enabled by the high Curie temperature, $BiScO_3$-$PbTiO_3$ cannot be directly used in most applications. This is the case of sensing technologies like accelerometers, vibration monitoring, hydrophones or magnetic field sensors, for which the voltage piezoelectric coef-ficient $g_{33}$ rather than the charge piezoelectric coefficient $d_{33}$ is the key parameter. This coefficient is equal to $d_{33}$ times the reciprocal permittivity that is very low (or the permittivity very high) in poled $BiScO_3$-$PbTiO_3$. CSIC has recently developed a high temperature piezoelectric $BiScO_3$-$PbTiO_3$ ceramic material chemically engineered for enhanced voltage response, suitable to these applications.

A common issue to all piezoelectric ceramics, to which $BiScO_3$-$PbTiO_3$ is not oblivious, is their low fracture toughness and thus, poor strength. This not only limits strain and stress operation levels, but often also makes machining difficult, even preventing the fabrication of ceramic elements with required nonconventional shapes and/or features. A possible solution is ceramic microstructure refinement down to the submicron range, which is a well known procedure to enhance mechanical performance. However, and in the case of ferroelectric ceramics, this is usually accompanied with a distinctive degradation of piezoelectric coefficients (see for instance Chapter 16. The effect of ceramic nanostructuring in high sensitivity piezoelectrics, by H. Amorín et al, in Nanoscale Ferroelectrics and Multiferroics, M. Algueró, J.M. Gregg and L. Mitoseriu eds., John Wiley & Sons Ltd. 2016, ISBN: 978-1-118-93575-0).

Therefore, and for the reasons stated above, it is needed to develop new piezoelectric ceramics that show good down-scaling behaviour of properties with grain size, capable to provide enhanced mechanical performance while maintaining full functionality.

**DESCRIPTION OF THE INVENTION**

The present invention discloses a piezoelectric ceramic material of formula $Bi_{1-x+2y}Pb_{x-3y}Sc_{1-x}Ti_xO_3$, wherein x ranges from 0.64 to 0.68 and y ranges from 0.01 to 0,025, which exhibits an enhanced electrochemical response at a perovskite morphotropic phase boundary between polymorphs of rhombohedral $R3m$ and tetragonal $P4mm$ sym-metries, high Curie temperature, and a point defect engineering for enhanced voltage response. Furthermore, the high temperature, high piezoelectric voltage coefficient ceramic of the present invention has a fully dense, ultrafine grained microstructure with an average grain size that can be tailored below 1 $\mu$m down to 0.15 $\mu$m. Specifically, ceramic materials with x=0.64 and y=0.01, densification above 99% and a grain size as low as 0.15 $\mu$m still have a Curie temperature above 400 ºC, and a $g_{33}$ coefficient of $\approx$ 1.6x10$^{-2}$ Vm/N that can be enhanced up to $\approx$ 3.5 x10$^{-2}$ Vm/N by a slight microstructure coarsening within the submicron range.

Moreover, the present invention discloses a process for obtaining said ceramic material that refers to its preparation by hot pressing of nanocrystalline powders derived by mechanosynthesis in a high energy planetary mill. The hot pressing procedure based on these highly reactive powders allows ultrafine grained ceramics approaching full densification to be obtained with enhanced mechanical performance, which maintain the functionality of fine grained materials obtained by conventional sintering of the same powders. Besides, $Bi_2O_3$ and PbO volatilization during hot pressing is not an issue because of low processing temperatures, so that stoichiometric mixtures of the precursors ($Bi_2O_3$, $Sc_2O_3$, PbO, and $TiO_2$) can be used. This is very advantageous for an accurate control of composition and phase coexistence while point defects are engineered, which cannot be reproducibly achieved by conventional ceramic technologies such as solid state synthesis by heating of precursors.

A first aspect of the present invention relates to a piezoelectric ceramic material of

- general formula $Bi_{1-x+2y}Pb_{x-3y}Sc_{1-x}Ti_xO_3$, wherein x ranges from 0.64 to 0.68 and y ranges from 0.01 to 0.025;
- perovskite single phase placed at a morphotropic phase boundary between polymorphs of rhombohedral *R3m* and tetragonal *P4mm* symmetries,

and characterized in that it has a fully dense, ultrafine microstructure with average grain size below 1 $\mu$m down to 0.15 $\mu$m.

The piezoelectric ceramic material of the present invention has perovskite single phase placed at a morphotropic phase boundary between polymorphs of rhombohedral *R3m* and tetragonal *P4mm* symmetries that is the responsible for the high piezoelectric response and, moreover, it includes an engineered point defect for enhanced voltage response that makes the material suitable to be used in sensing technologies.

The term "engineered point defect" refers to a point defect that is introduced at or around a single lattice point of the perovskite, specifically by the controlled substitution of $Bi^{3+}$ for $Pb^{2+}$ in the A-site (cuboctahedral coordination) of the $ABO_3$ perovskite, along with the formulation of one Pb vacancy per each two substitutions for charge compensation. This controlled substitution that does not require additional chemical species, but the introduction of an A-site non-stoichiometry, results in significant lattice stiffening and thus, a decrease of the dielectric permittivity and elastic compliance. Moreover, this controlled substitution is achieved while the material is maintained at the morphotropic phase boundary between polymorphs of rhombohedral *R3m* and tetragonal *P4mm* symmetries, known to be required for high piezoelectric response.

Additionally, microstructure is refined at the same time point defects are introduced, so that an optimized fully dense, this means densification above 99%, ultrafine-grained microstructure is obtained by hot pressing for optimal mechanical performance.

The term "ultrafine grained microstructure" is used herein to refer to an average grain size of less than 1 $\mu$m.

In a preferred embodiment of the material of the present invention, the piezoelectric ceramic material of the present invention has a fully dense and ultrafine grained microstructure with average grain size of between 0.5 and 0.15 $\mu$m.

In another preferred embodiment of the material of the present invention, the piezoelectric ceramic material mentioned above has the formula $Bi_{1-c+2y}Pb_{x-3y}Sc_{1-x}Ti_xO_3$, wherein x = 0.64 and y = 0.01.

A second aspect of the present invention relates to a procedure for obtaining the piezoelectric ceramic material mentioned above, characterized in that it comprises the following steps:

a) preparation of a nanocrystalline powder of formula $Bi_{1-x+2y}Pb_{x-3y}Sc_{1-x}Ti_xO_3$, by mechanosynthesis from a stoichiometric mixture of $Bi_2O_3$, $Sc_2O_3$, PbO, and $TiO_2$, wherein x ranges from 0.64 to 0.68 and y ranges from 0.01 to 0.025; and

b) hot pressing of the nanocrystalline powder obtained in step (a)

- at a temperature range of between 1100 ºC and 900 ºC for soaking times between 5 h and 30 min, or
- at a pressure range of between 30 and 90 MPa for soaking times between 5 h and 30 min.

The relationship between the grain size and temperature or the time can be simplified by considering that a decrease of the grain size is obtained at low temperatures and short soaking times, while the relationship between the grain size and pressure is the opposite; a decrease of the grain size is obtained at high pressures.

Therefore, for obtaining a fully dense microstructure with average grain size of between 1 $\mu$m and 0.15 $\mu$m, there are two possible way of performing step (b) of hot pressing of the nanocrystalline powder obtained in step (a):

- fixing a pressure and varying the temperature in a range of between 1100 ºC and 900 ºC for soaking times between 5 h and 30 min

- or fixing a temperature and varying the pressure range of between 30 MPa and 90 MPa, for soaking times between 5 h and 30 min.

Step (a) is preferably performed in a planetary mill at 300 rpm for 20 h.

Step (a) is also preferably performed for the mechanosynthesis of a nanocrystalline powder of formula

$Bi_{1-x+2y}Pb_{x-3y}Sc_{1-x}Ti_xO_3$, wherein x is 0.64 and y is 0.01.

A third aspect of the invention refers to a magnetoelectric composite characterized in that it comprises

- the piezoelectric ceramic material mentioned above; and
- a magnetostrictive material.

The term "magnetostrictive material" refers to a ferromagnetic material that changes its shape or dimensions during the process of magnetization.

In a preferred embodiment of the magnetoelectric composite of the present invention, it is characterized in that it is of particulate, fiber or laminate type. The names "particulate", "fiber" and "laminate" magnetoelectric composites are used herein to refer to the following three connectivity schemes: phase connectivity is 0-3, 1-3 or 2-2, wherein the first digit refers to the magnetostrictive phase, and the second digit to the piezoelectric one.

In more preferred embodiment of the magnetoelectric composite of the present invention, it is characterized in that

- it is in the form of a laminate of at least one layer of the piezoelectric ceramic material of thickness between 10 $\mu$m and 1 mm and one layer of the magnetostrictive material of thickness between 10 $\mu$m and 1 mm, and
- the magnetostrictive material is selected from the list consisting of Terfenol-D, Metglass, spinel oxides of formula $AFe_2O_4$, wherein A is Ni, Co, Zn or a combination thereof, and a combination thereof.

The layered magnetoelectric composite has at least one layer of the piezoelectric ceramic material and one layer of the magnetostrictive material, but it is not limited to be a two layered laminate.

The layered magnetoelectric composite of the present invention may have a plurality of successive layers having alternating composition, one layer of the piezoelectric ceramic material and one layer of the magnetostrictive material.

The process for obtaining said layered magnetic composite is characterized in that it comprises the steps of the process according to the second aspect of the invention for obtaining the piezoelectric ceramic material and a further step c) of bonding at least the one layer of the piezoelectric ceramic material and the one layer of the magnetostrictive material by means of an adhesive.

Examples of adhesives are epoxy resins, silicone systems or polyurethanes.

In a more preferred embodiment, the above mentioned layered magnetoelectric composite is characterized in that the magnetostrictive material is a spinel oxide of formula $AFe_2O_4$, wherein A is Ni, Co, Zn or a combination thereof. The process for obtaining said layered magnetoelectric composite is characterized in that it comprises the following steps

a) preparation of a nanocrystalline powder of formula $Bi_{1-x+2y}Pb_{x-3y}Sc_{1-x}Ti_xO_3$ by mechanosynthesis from a stoichiometric mixture of $Bi_2O_3$, $Sc_2O_3$, PbO and $TiO_2$, wherein x ranges from 0.64 to 0.68 and y ranges from 0.01 to 0.025;

a1) preparation of a green ceramic laminate using the nanocrystalline powder obtained in step (a), preferably this step (a1) is performed by uniaxial pressing and/or tape casting;
a2), preparation of the spinel oxide of formula $AFe_2O_4$, wherein A is Ni, Co, Zn or a combination thereof, in the form of a green ceramic laminate;
a3) stacking at least one layer of the green ceramic obtained on step (a1) and at least one layer of green ceramic laminate obtained in step a2); and

b) hot pressing of the laminate obtained in step (a3)

- at a temperature range of between 1100 ºC and 900 ºC for soaking times between 5 h and 30 min, or
- at a pressure range of between 30 and 90 MPa for soaking times between 5 h and 30 min.

In another preferred embodiment of the magnetoelectric composite of the present invention is characterized in that

- it is in the form of a particulate and
- the magnetostrictive material is a spinel oxide of formula $AFe_2O_4$, wherein A is Ni, Co, Zn or a combination thereof.

The process for obtaining said magnetoelectric particulate composite is characterized in that it comprises steps (a) and (b) of the process for obtaining the piezoelectric ceramic material mentioned above and a further step a'), between steps (a) and (b), of mixing the nanocrystalline powder obtained in step (a) and the spinel oxide of formula $AFe_2O_4$.

Another aspect of the present invention refers to the use of the piezoelectric ceramic material as described above, as part of a sensing device. Examples of sensing devices are accelerometers, vibration monitoring or hydrophones. The piezoelectric ceramic material of the present invention is the active element in these sensing technologies.

The last aspect of the invention refers to the use of the magnetoelectric composites described above as part of a magnetic sensing device such as a magnetic transducer. The magnetoelectric composites of the present invention comprising the piezoelectric ceramic material of the present invention and a magnetostrictive material are the active element in magnetic sensing technologies.

Unless otherwise defined, all technical and scientific terms used herein have the same meaning as commonly understood by one of ordinary skilled in the art to which this invention belongs. Methods and materials similar or equivalent to those described herein can be used in the practice of the present invention. Throughout the description and claims the word "comprise" and its variations are not intended to exclude other technical features, additives, components, or steps. Additional objects, advantages and features of the invention will become apparent to those skilled in the art upon examination of the description or may be learned by practice of the invention. The following examples and drawings are provided by way of illustration and are not intended to be limiting of the present invention.

## BRIEF DESCRIPTION OF THE DRAWINGS

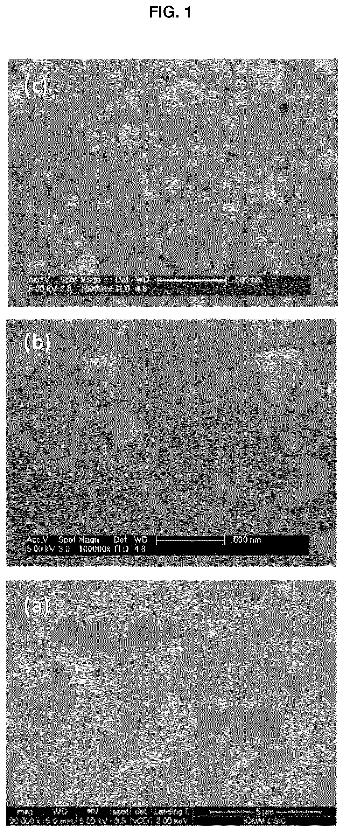

FIG. 1 Scanning electron microscopy (SEM) images of $Bi_{1-x+2y}Pb_{x-3y}Sc_{1-x}Ti_xO_3$ ceramic samples with x = 0.64 and y = 0.01, processed by either (a) conventional sintering at 1125 $\underline{o}$C for a grain size of ~1.4 $\mu$m, or hot pressing at 60 MPa and (b) 1000 $\underline{o}$C or (c) 900 $\underline{o}$C for fully dense and ultrafine grained microstructures.

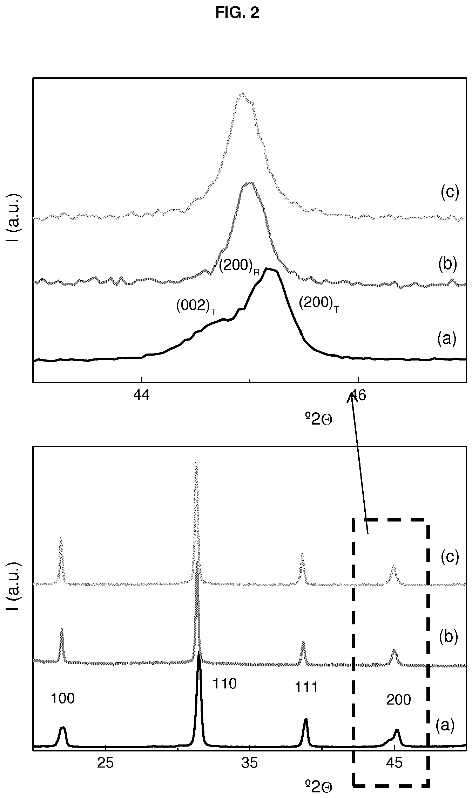

FIG. 2 XRD patterns for $Bi_{1-x+2y}Pb_{x-3y}Sc_{1-x}Ti_xO_3$ ceramic samples with x = 0.64 and y = 0.01, processed by either (a) conventional sintering at 1125 $\underline{o}$C, or hot pressing at 60 MPa and (b) 1000 $\underline{o}$C or (c) 900 $\underline{o}$C, showing the absence of secondary phases other than perovskite in all cases. The °2$\theta$ range across the perovskite parent cubic phase 200 diffraction peak is expanded to show polymorphic phase coexistence and thus, location of all materials with decreasing grain size down to the submicron range at the morphotropic phase boundary.

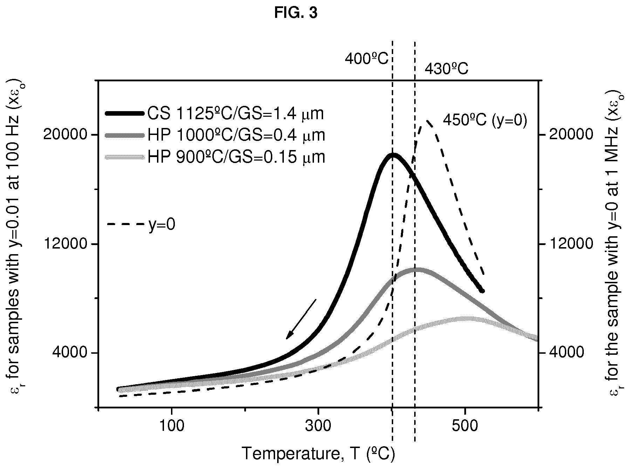

FIG. 3 Temperature dependence of the relative permittivity for $Bi_{1-x+2}yPb_{x-3y}Sc_{1-x}Ti_xO_3$ ceramic samples with x = 0.64 and y = 0.01, processed by either conventional sintering (CS) or hot pressing (HP), showing the position of the ferroelectric transition (that determines the maximum operation temperature). Permittivity for a $Bi_{0.36}Pb_{0.64}SC_{0.36}Ti_{0.64}O_3$ fine grained ceramic is included (dashed line: CS 1100 $\underline{o}$C / GS = 2.4 $\mu$m) in order to illustrate the shift of the critical temperature after point defect introduction for all materials with decreasing grain size (GS) down to the submicron range.

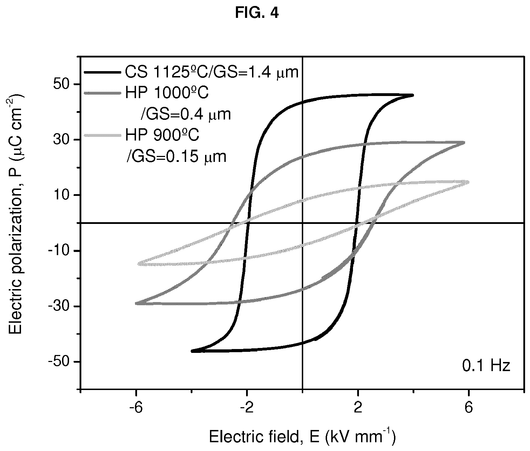

FIG. 4 Ferroelectric hysteresis loops for $Bi_{1-x+2y}Pb_{x-3y}Sc_{1-x}Ti_xO_3$ ceramic samples with x = 0.64 and y = 0.01, processed by either conventional sintering (CS) or hot pressing (HP). Note the distinctive decrease of remnant polarization with grain size across the submicron range.

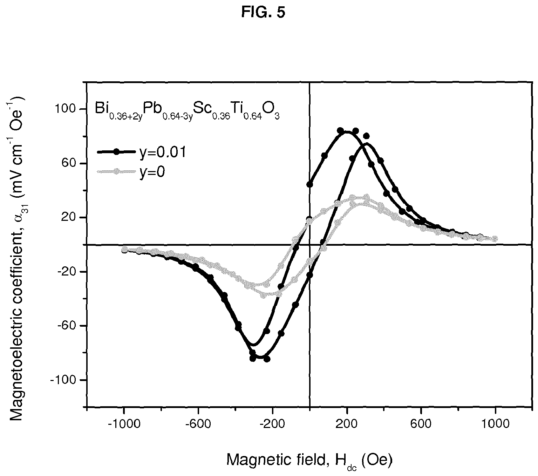

FIG. 5 Magnetoelectric voltage coefficient of hot pressed ceramic $Bi_{1-x+2y}Pb_{x-3y}Sc_{1-x}Ti_xO_3/Ni_{0.7}Zn_{0.3}Fe_2O_4/Bi_{1-x+2y}Pb_{x-3y}SC_{1-x}Ti_xO_3$ three-layer structures with x=0.64 and y=0.01 (chemically modified piezoelectric) and 0 (unmodified), showing the enhanced voltage response after introducing the point defects.

## EXAMPLES

### Preparation of ultrafine grained $Bi_{1-x+2y}Pb_{x-3y}Sc_{1-x}Ti_xO_3$ ceramic samples with x = 0.64 and y = 0.01

Perovskite single phase nanocrystalline powders of $Bi_{1-x+2y}Pb_{x-3y}Sc_{1-x}Ti_xO_3$ with x = 0.64 and y = 0.01 were derived by mechanosynthesis from stoichiometric mixtures of analytical grade $Bi_2O_3$ (Aldrich, 99.9% pure), $Sc_2O_3$ (Aldrich, 99.9% pure), PbO (Merck, 99% pure) and $TiO_2$ (anatase, Cerac, 99% pure) with a Pulverisette 6 model Fritsch planetary mill. About 10 g of the mixture of the precursor oxides was initially homogenized by hand in an agate mortar, and placed in a tungsten carbide (WC) jar of 250 ml with seven, 2 cm diameter, 63 g mass each WC balls for mechanical activation at 300 r.p.m. for 20 h.

These conditions provide perovskite single phase fully crystalline powders with nanometer-scale chemical homogeneity.

About 1 g of nanocrystalline powder was uniaxially pressed into 12 mm diameter pellets, which were then hot pressed at temperatures of 1000 $\underline{o}$C and 900 $\underline{o}$C and under a pressure of 60 MPa. Fully dense, ultrafine grained microstructures with decreasing average grain size were so obtained (HP). Pressure was applied once the targeted temperature was reached, and released when cooling started. A soaking time of 1 h and heating/cooling rates of $\pm$ 3 ºC/ min were selected.

Note that PbO or $Bi_2O_3$ losses did not take place at these low temperatures, so that the use of stoichiometric mixtures of precursors was allowed. This is essential for an accurate composition and phase coexistence control, which is the key to high sensitivity. Here microstructure is engineered down to the submicron range while maintaining full control of the perovskite structural characteristics and the introduced point defects.

Additionally, and aiming to provide comparative data, a fine grained material was also processed by conventional sintering at 1125 ºC for comparison. An average grain size of 1.4 $\mu$m was so obtained. These samples are hereinafter referred to as *conventional sintering (CS) samples.*

## Characterization of the piezoelectric ceramic materials

Samples for phase and microstructural characterizations were prepared by thinning of ceramics to remove one surface (~100 $\mu$m), followed by polishing to a mirror finish. A final thermal treatment at 600 ºC for 2h with $\pm$ 0.5 ºC/min was carried out to remove the damage introduced, and to restore the equilibrium polymorphic phase coexistence and domain configurations, which are modified by the shear stresses involved in polishing.

Phases and perovskite phase characteristics were controlled by X-ray diffraction (XRD) with a Bruker AXS D8 Advance diffractometer and $CuK_\alpha$ radiation ($\lambda$=1.5418 Å). Patterns were recorded between 20 and 50º ($2\theta$) with 0.05º ($2\theta$) step and 0.3 s counting time.

Microstructure was studied with a Philips XL30 S-FEG field emission gun scanning electron microscope on sample pieces that had been quenched from 850 ºC for revealing grain boundaries.

Ceramic capacitor for electrical and electromechanical characterizations were prepared by thinning discs down 0.5 mm, painting of Ag electrodes on the major faces, and their sintering at 700 ºC.

Electrical characterization involved the characterization of dielectric permittivity and ferroelectric hysteresis loops. Dependences of the dielectric permittivity and losses on temperature were measured between room temperature (RT) and 600 ºC with an Agilent E4980A precision LCR meter. Measurements were dynamically carried out during a heating/cooling cycle with $\pm$1.5 ºC/min rate at several frequencies between 100 Hz and 1 MHz. Room temperature ferroelectric hysteresis loops were recorded under voltage sine waves of increasing amplitude up to 10 kV with a 0.1 Hz frequency, obtained by the combination of a synthesizer/function generator (HP 3325B) and a high voltage amplifier (TREK model 10/40), while charge was measured with a homebuilt charge to voltage converter and software for loop acquisition and analysis.

Finally, the ceramic discs were poled for electromechanical characterization. A field of 7 kV/mm was applied at 100 ºC for 15 min, and maintained during cooling down to 40 ºC. The longitudinal piezoelectric coefficient $d_{33}$ was then measured 24 h after the poling step with a Berlincourt type meter. Also, the transverse piezoelectric coefficient was obtained by complex analysis of piezoelectric radial resonances of the discs by the automatic iterative method described in C. Alemany et al J Phys D: Appl Phys 1995; 28:945. This procedure also provides the $s_{11}^E$ and $s_{12}^E$ compliances and $\varepsilon_{33}^\sigma$ permittivity of the poled material all in complex form and thus, all mechanical, electrical and electromechanical losses.

It is worth remarking the enhanced dielectric strength of the hot pressed materials. Indeed, these submicrostructured ceramics withstood fields as high as 7 kV/mm without undergoing breakdown, which are well above typical ones for $BiScO_3$-$PbTiO_3$ coarse and fine grained materials. There is direct correlation between dielectric and mechanical strength, which is also indicated by the remarkably good performance of the ceramic samples during machining.

## Preparation and characterization of a magnetoelectric composite with the piezoelectric ceramic samples

Finally, ceramic magnetoelectric composites were processed by hot pressing of two piezoelectric $Bi_{1-x+2y}Pb_{x-3y}Sc_{1-x}Ti_xO_3$ with x = 0.64 and y = 0.01 layers and one magnetostrictive $Ni_{0.7}Zn_{0.3}Fe_2O_4$ one alternatively stacked. A temperature of 1000 ºC and a pressure of 60 MPa were selected. Pressure was applied once the targeted temperature was reached, and released after cooling down to 333ºC. A soaking time of 1 h and heating/cooling rates of +3/-1 ºC/ min, were used, Dense, crack-free layered composite discs (12 mm diameter and 2 mm thickness) were so obtained, whose magnetoelectric response was characterized after a poling step with 3 kV mm$^{-1}$ at 100ºC. A system comprising a combination of two Helmholtz coils, designed to independently provide a static magnetic field up to 1 kOe to magnetize the material, and an alternate magnetic field up to 10 Oe at 10 kHz to play as stimulus (Serviciencia S.L.), was used, while the magnetoelectric voltage response was monitored with a lock-in amplifier. A 31 geometry was chosen to obtain the transverse magnetoelectric coefficient $\alpha_{31}$ as a function of the bias magnetic field $H$, after normalization to the piezoelectric element thickness (1 mm).

**Results**

Scanning electron microscopy (SEM) images of the hot pressed ceramics are shown in Figure 1. A homogenous, ultrafine-grained microstructure with average grain size of ~0.4 $\mu$m was obtained when processing was carried out at 1000 $\underline{o}$C, which was further decreased down to ~0.15 $\mu$m when temperature was lowered down to 900 $\underline{o}$C. A SEM image of the fine grained material processed by conventional sintering is also included as reference for the rest of figures.

XRD patterns for the hot pressed ceramic materials are shown in Figure 2, along with that for the conventional sintering sample. No secondary phases in addition to the perovskite one are found for any ceramic, suggesting the targeted incorporation of the point defects into the structure for all materials including those with ultrafine microstructure.

Patterns across the perovskite parent cubic phase 200 diffraction peak are expanded in the Figure. Note polymorphic phase coexistence and thus, location of the material with fine grained microstructure (CS) at the morphotropic phase boundary. An apparently single, but very broad peak was found for the ultrafine grained materials (HP). This might indicate a significant increase in the percentage of rhombohedral phase, but peak width rather suggests a decrease in the *c/a* tetragonal distortion. This later effect has been widely observed for tetragonal perovskite oxides when grain size is decreased across the submicron range.

Point defect incorporation into the perovskite is also indicated by the decrease of the ferroelectric transition temperature with the A-site non-stoichiometry, evaluated from the position of the dielectric anomaly. This is illustrated in Figure 3, where the temperature dependence of permittivity is shown for the hot pressed materials, along with that for the ceramic processed by conventional sintering. The dielectric anomaly associated with the transition is observed at a temperature of ~430$\underline{o}$C for the case of ultrafine grained materials (HP), and at $\approx$400$\underline{o}$C for the fine grained ceramic (CS). There seems to be thus a slight shift of the transition temperature towards high temperatures with the decrease of grain size. This might indicate partial point defect incorporation at low processing temperatures, yet the temperature of 430$\underline{o}$C is still far from the value of 450$\underline{o}$C, characteristic of the unmodified $BiScO_3$-$PbTiO_3$ composition. Permittivity for one such material is included for comparison. Note that curves at 100 Hz are given for the materials with y = 0.01, while permittivity at 1 MHz is shown for that with y = 0. This is due to the existence of a high temperature dielectric relaxation for the former case that overlaps with the transition anomaly at high frequency, and of high temperature conductivity in the latter case that masks the anomaly at low frequency. Chosen curves are reckoned to be the most suitable for identifying the transition in each case.

Room temperature dielectric permittivity and losses of the unpoled ceramics showed no significant changes after grain size decrease down to the submicron range. Specific values are given in Table I, along with $T_C$s. Indeed the materials with y = 0.01 and ultrafine grained microstructure maintain permittivity values larger than that of the fine grained material with y = 0, whose parameters are also included in the table. This has been associated with a slight enhancement of domain wall mobility as a result of the point defect introduction, which further confirms the presence of the A-site non-stoichiometry after microstructure refinement.

Unlike the room temperature permittivity, ferroelectric hysteresis loops do show significant changes after microstructure refinement down to the submicron range. A significant decrease of remnant polarization, from a value of 44 $\mu$C/cm$^2$ for a grain size of 1.4 $\mu$m, down to 24 and 8 $\mu$C/cm$^2$ for grain sizes of 0.4 and 0.15 $\mu$m resulted. This trend has already been described for unmodified $BiScO_3$-$PbTiO_3$, and it has been associated with a grain boundary effect resulting in a continual increase of the effective coercive field with the grain size decrease.

Charge longitudinal and transverse piezoelectric coefficients after poling are given in Table I, along with permittivity and compliance values. Note the distinctive decrease of the piezoelectric coefficients with the reduction of grain size across the submicron range, below 0.5 $\mu$m. This is consistent with the described decrease of the remnant polarization, and can be understood as a consequence of the continual increase of the effective coercive field as the grain boundary fraction raise. Note nonetheless that materials with an average grain size as low as 0.15 $\mu$m still present a $d_{33}$ coefficient of $\approx$ 155 pC/N that is enhanced up to $\approx$ 300 pC/N after a slight microstructure coarsening within the submicron range up to 0.4 $\mu$m.

Moreover, these ultrafine-grained materials maintain low permittivity after poling, characteristic of the point defect engineered $BiScO_3$-$PbTiO_3$ (see Table). As a result, the material with an average grain size of 0.4 $\mu$m has a high voltage piezoelectric coefficient of 3.5x10$^{-2}$ Vm/N. This value is larger than that of unmodified $BiScO_3$-$PbTiO_3$ with a grain size of 2.4 $\mu$m ($g_{33}$=3.3x10$^{-2}$ Vm/N), in spite of the significant decrease of $d_{33}$ with grain size. The figure is also higher than that of commercially available chemically engineered PZTs with $g_{33}$ values ranging between 2 and-2.8x10$^{-2}$ Vm/N.

Furthermore, the ultrafine grained materials maintain reduced elastic compliances too, also characteristic of the point defect engineered $BiScO_3$-$PbTiO_3$ (see also Table). Both effects of the A-site non-stoichiometry have been associated with an overall increase of the lattice rigidity with a direct effect on polarizability and deformability.

A new application of high sensitivity piezoelectrics is magnetoelectric composites, in which they are combined with magnetostrictive materials to provide magnetoelectricity as a product property. Magnetoelectric transducers are being considered for a range of technologies like high sensitivity, room temperature operation magnetic field sensors.

It has been shown that the voltage magnetoelectric coefficient of the simplest two-layer piezoelectric-magnetostrictive structure is given by:

$$\alpha_{E,31} = \frac{\partial E_3}{\partial H_1} = \frac{-2d_{31}^p q_{11}^m v_m}{\left(s_{11}^m + s_{12}^m\right)\varepsilon_{33}^p v_p + \left(s_{11}^p + s_{12}^p\right)\varepsilon_{33}^p v_m - 2\left(d_{31}^p\right)^2 v_m}$$

Where $d$ and $q$ are the piezoelectric and piezomagnetic coefficients of the respective phases of volume $v$, $s$ are the elastic compliances, and $\varepsilon$ the permittivity, while superindex $p$ and $m$ refer to the piezoelectric and magnetic component, respectively. Note that the voltage response not only increases with the reciprocal permittivity, but also with the reciprocal compliances. Therefore, current materials are specially suitable for this application.

This is illustrated in Figure 5, where the magnetoelectric voltage coefficient of a hot pressed, ceramic three-layer structure, consisting of $Bi_{1-x+2y}Pb_{x-3y}Sc_{1-x}Ti_xO_3$ with x = 0.64 and y = 0.01 and $Ni_{0.7}Zn_{0.3}Fe_2O_4$, is compared with that of a composite with the same geometry, but including unmodified $BiScO_3$-$PbTiO_3$ (x=0.64, y=0). Indeed, the magnetoelectric coefficient is increased from 35 up to 85 mV cm$^{-1}$ Oe$^{-1}$ when the point defect engineered piezoelectric is used.

*Table I. Material coefficients for the $Bi_{1-x+2y}Pb_{x-3y}Sc_{1-x}Ti_xO_3$ ceramic samples with x = 0.64 and y = 0.01, processed by conventional sintering (CS) or hot pressing (HP). Parameters for a ceramic with x=0.64 and y=0 (CS) are also given*

| | Grain size ($\mu$m) | $\varepsilon_{33}\sigma$ Unpoled ($x\varepsilon_o$) | Tan $\delta$ Unpoled | $T_c$ (°C) | $d_{33}$ (pC/N) | $d_{31}$ (pC/N) | $\varepsilon_{33}^\sigma$ ($x\varepsilon_o$) Poled | $s_{11}^E$ (x10$^{-12}$ m$^2$/N) | $s_{12}^E$ (x10$^{-12}$ m$^2$/N) |
|---|---|---|---|---|---|---|---|---|---|
| y=0 CS | 2.4 | 835 | 0.095 | 450 | 440 | -144+15i | 1486-143i | 138-0.7i | -3.6+0.2i |
| y=0.01 CS | 1.4 | 920 | 0.105 | 400 | 412 | -115+10i | 966-85i | 11.7-0.5i | -2.7+0.1i |
| HP at 1000°C | 04 | 910 | 0.096 | 430 | 301 | -93+8i | 976-74i | 11.7-0.3i | -3.2+0.09i |
| HP at 900°C | 0.15 | 893 | 0.089 | 430 | 154 | -54+4i | 1016-67i | 10.8-0.2i | -3.4+0.07i |

## Claims

1. A piezoelectric ceramic material of:

   • general formula $Bi_{1-x+2y}Pb_{x-3y}Sc_{1-x}Ti_xO_3$, wherein x ranges from 0.64 to 0.68 and y ranges from 0.01 to 0.025;
   • perovskite single phase placed at a morphotropic phase boundary between polymorphs of rhombohedral *R*3*m* and tetragonal *P*4*mm* symmetries;

   and **characterized in that** it has a fully dense ultrafine microstructure with average grain size below 1 $\mu$m down to 0.15 $\mu$m.

2. The piezoelectric ceramic material according to claim 1, **characterized in that** it has a fully dense and ultrafine grained microstructure with average grain size of between 0.5 $\mu$m and 0.15 $\mu$m.

3. The piezoelectric ceramic material according to any of claims 1 to 2, **characterized in that** it has the formula $Bi_{1-x+2y}Pb_{x-3y}Sc_{1-x}Ti_xO_3$, wherein x=0.64 and y=0.01.

4. A process for obtaining the piezoelectric ceramic material according to any of claims 1 to 3, **characterized in that** it comprises the following steps:

   a) preparation of a nanocrystalline powder of formula $Bi_{1-x+2y}Pb_{x-3y}Sc_{1-x}Ti_xO_3$ by mechanosynthesis from a stoichiometric mixture of $Bi_2O_3$, $Sc_2O_3$, PbO and $TiO_2$, wherein x ranges from 0.64 to 0.68 and y ranges from 0.01 to 0.025; and

b) hot pressing of the nanocrystalline powder obtained in step (a)

- at a temperature range of between 1100 ºC and 900 ºC for soaking times between 5 h and 30 min, or
- at a pressure range of between 30 and 90 MPa for soaking times between 5 h and 30 min.

5. The process for obtaining according to claim 4, **characterized in that** step (a) is performed for the synthesis of a nanocrystalline powder of formula $Bi_{1-x+2y}Pb_{x-3y}SC_{1-x}Ti_xO_3$, wherein x is 0.64 and y is 0.01.

6. A magnetoelectric composite **characterized in that** it comprises

- the piezoelectric ceramic material according to any of claims 1 to 3; and
- a magnetostrictive material.

7. The magnetoelectric composite according to claim 6, **characterized in that** it is of particulate, fiber or laminate type.

8. The magnetoelectric composite according to any of claims 6 or 7, **characterized in that**

- it is in the form of a laminate of at least one layer of the piezoelectric ceramic material with thickness between 10 $\mu$m and 1 mm and one layer of the magnetostrictive material with thickness between 10 $\mu$m and 1 mm, and
- the magnetostrictive material is selected from the list consisting of Terfenol-D, Metglass, spinel oxides of formula $AFe_2O_4$, wherein A is Ni, Co, Zn or a combination thereof, and a combination thereof.

9. A process for obtaining a magnetoelectric composite according to claim 8 **characterized in that** it comprises the steps of the process for obtaining a piezoelectric ceramic material according to any of claims 4 or 5, and a further step c) of bonding at least the one layer of the piezoelectric ceramic material and the one layer of the magnetostrictive material by means of an adhesive.

10. The magnetoelectric composite according to claim 8, **characterized in that** the magnetostrictive material is a spinel oxide of formula $AFe_2O_4$, wherein A is Ni, Co, Zn or a combination thereof.

11. A process for obtaining a magnetoelectric composite according to claim 10 **characterized in that** it comprises the following steps

a) preparation of a nanocrystalline powder of formula $Bi_{1-x+2y}Pb_{x-3y}Sc_{1-x}Ti_xO_3$ by mechanosynthesis from a stoichiometric mixture of $Bi_2O_3$, $Sc_2O_3$, PbO and $TiO_2$, wherein x ranges from 0.64 to 0.68 and y ranges from 0.01 to 0.025;

a1) preparation of a green ceramic laminate using the nanocrystalline powder obtained in step (a);
a2) preparation of the spinel oxide of formula $AFe_2O_4$, wherein A is Ni, Co, Zn or a combination thereof, in the form of a green ceramic laminate;
a3) stacking at least one layer of the green ceramic obtained on step (a1) and at least one layer of the green ceramic laminate obtained in step a2); and

b) hot pressing of the laminate obtained in step (a3)

- at a temperature range of between 1100 ºC and 900 ºC for soaking times between 5 h and 30 min, or
- at a pressure range of between 30 and 90 MPa for soaking times between 5 h and 30 min.

12. The magnetoelectric composite according to any of claims 6 or 7, **characterized in that**

- it is in the form of a particulate and
- the magnetostrictive material is a spinel oxide of formula $AFe_2O_4$, wherein A is Ni, Co, Zn or a combination thereof.

13. A process for obtaining the magnetoelectric composite according to claim 12, **characterized in that** it comprises the steps of the process for obtaining the piezoelectric ceramic material according to any of claims 4 or 5 and a further step a'), between steps (a) and (b), of mixing the nanocrystalline powder obtained in step (a) and the spinel

oxide of formula $AFe_2O_4$.

14. Use of the piezoelectric ceramic material according to any of claims 1 to 3 as part of a sensing device.

15. Use of the magnetoelectric composite according to any of claims 6 to 8, 10 or 12 as part of a magnetic sensing device.

**FIG. 1**

**FIG. 2**

FIG. 3

FIG. 4

FIG. 5

Europäisches
Patentamt

European
Patent Office

Office européen
des brevets

# EUROPEAN SEARCH REPORT

Application Number

EP 17 38 2320

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| E,D | WO 2017/109096 A1 (CONSEJO SUPERIOR DE INVESTIG CIENTÍFICAS [ES]) 29 June 2017 (2017-06-29) * Page 7, lines 21-27; claims 1,3,4; table 1 * | 1-15 | INV. C04B35/462 C04B35/472 C04B35/626 C04B35/64 H01L41/43 |
| E | WO 2017/114741 A1 (CONSEJO SUPERIOR DE INVESTIG CIENTIFICAS [ES]) 6 July 2017 (2017-07-06) * Abstract; page 7, lines 17-20; claims 1,4; figure 3; examples 1-3; table 1 * | 1-15 | H01L41/187 H01G4/12 G01R33/09 H01L43/08 |
| A | US 6 835 684 B2 (FORSCHUNGSZENTRUM JUELICH GMBH [DE]) 28 December 2004 (2004-12-28) * Abstract; column 3, lines 27-54; claims 1,8,12,16 * | 1-15 | |
| A | MICHAEL D. DRAHUS ET AL: "Manganese-doped (1 - x)BiScO3-xPbTiO3 high-temperature ferroelectrics: Defect structure and mechanism of enhanced electric resistivity", PHYSICAL REVIEW. B, CONDENSED MATTER AND MATERIALS PHYSICS, vol. 84, no. 6, 1 August 2011 (2011-08-01) , XP055346893, US ISSN: 1098-0121, DOI: 10.1103/PhysRevB.84.064113 * Section II. "Experimental"; page 6, Table I, sample A; section V "Conclusion and Outlook" * | 1-15 | |

TECHNICAL FIELDS SEARCHED (IPC)

C04B
H01L
H01G
G01R

-/--

The present search report has been drawn up for all claims

| Place of search | Date of completion of the search | Examiner |
|---|---|---|
| Munich | 20 November 2017 | Vathilakis, S |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

**EUROPEAN SEARCH REPORT**

Application Number

EP 17 38 2320

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | LIN ZHANG ET AL: "Preparation and characterization of high T c (1-x) BiScO3-xPbTiO3 ceramics from high energy ball milling process", JOURNAL OF ELECTROCERAMICS, KLUWER ACADEMIC PUBLISHERS, BO, vol. 21, no. 1-4, 17 August 2007 (2007-08-17), pages 605-608, XP019678792, ISSN: 1573-8663 * Section 2 "Experimental"; page 608, left column, pemultimate paragraph; "Conclusions" * ----- | 1-6 | |

TECHNICAL FIELDS
SEARCHED      (IPC)

The present search report has been drawn up for all claims

| Place of search | Date of completion of the search | Examiner |
|---|---|---|
| Munich | 20 November 2017 | Vathilakis, S |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
...............................................................................
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 17 38 2320

This annex lists the patent family members relating to the patent documents cited in the above-mentioned European search report.
The members are as contained in the European Patent Office EDP file on
The European Patent Office is in no way liable for these particulars which are merely given for the purpose of information.

20-11-2017

| Patent document cited in search report | | | Publication date | Patent family member(s) | | | Publication date |
|---|---|---|---|---|---|---|---|
| WO 2017109096 | A1 | | 29-06-2017 | ES | 2628027 | A1 | 01-08-2017 |
| | | | | WO | 2017109096 | A1 | 29-06-2017 |
| WO 2017114741 | A1 | | 06-07-2017 | ES | 2620690 | A1 | 29-06-2017 |
| | | | | WO | 2017114741 | A1 | 06-07-2017 |
| US 6835684 | B2 | | 28-12-2004 | AT | 369323 | T | 15-08-2007 |
| | | | | DE | 10059280 | A1 | 20-06-2002 |
| | | | | DK | 1337496 | T3 | 10-12-2007 |
| | | | | EP | 1337496 | A1 | 27-08-2003 |
| | | | | ES | 2291381 | T3 | 01-03-2008 |
| | | | | JP | 4383740 | B2 | 16-12-2009 |
| | | | | JP | 2004517791 | A | 17-06-2004 |
| | | | | US | 2004047789 | A1 | 11-03-2004 |
| | | | | WO | 0244103 | A1 | 06-06-2002 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- Chapter 16. The effect of ceramic nanostructuring in high sensitivity piezoelectrics. **H. AMORÍN et al.** Nanoscale Ferroelectrics and Multiferroics. John Wiley & Sons Ltd, 2016

- **C. ALEMANY et al.** *J Phys D: Appl Phys,* 1995, vol. 28, 945